# EUROPEAN PATENT SPECIFICATION

(11) **EP 3 450 833 B1**
(45) Date of publication and mention of the grant of the patent: **02.11.2022**
(21) Application number: 17382588.6
(22) Date of filing: 31.08.2017
(51) Int. Cl.: F21S 43/14, F21S 43/19, F21S 41/151, F21S 41/19, H05K 1/18, F21S 41/663, B60Q 1/26, H01L 25/075, F21Y 107/50, F21Y 107/70

(54) **ELECTRONIC DEVICE AND LIGHTING MODULE**
ELEKTRONISCHE VORRICHTUNG UND BELEUCHTUNGSMODUL
DISPOSITIF ÉLECTRONIQUE ET MODULE D'ÉCLAIRAGE

(43) Date of publication of application: 06.03.2019
(73) Proprietor: Valeo Iluminacion, 23600 Martos (ES)
(72) Inventor: ROLDAN, Jose-David, 23600 MARTOS (ES); CANTUDO, Miguel Angel, 23600 MARTOS (ES)
(74) Representative: Valeo Visibility

(56) References cited:
- EP-A2- 0 980 788
- US-A- 5 490 049
- US-A1- 2004 223 328
- US-A1- 2010 066 249
- US-B1- 6 299 337
- US-B1- 6 520 669

## Description

### TECHNICAL FIELD

This invention belongs to the field of lighting devices installed in automotive vehicles, and more specifically to the printed circuit boards used in these lighting devices.

### STATE OF THE ART

Lighting devices installed in automotive vehicles usually comprise light sources mounted on a flexible printed circuit board (FPCB).

These FPCBs mount an increasing number of LEDs, and each one is usually controlled individually, as to achieve some effects as "coming home", "running turn-indicator" or "anti-glare high beam".

The development of these functions leads to a great number of electronic elements comprised in a single FPCB, and its size becomes a critical parameter to be minimized.

Some solutions have been developed to face this issue. The most commonly known is using the two faces of the FPCB to install electronic elements in them. Thus, the size of the FPCB may be reduced to the half, but this solution creates different problems, regarding the use of metal stiffeners and other problems related to heat dissipation.

Document US2004223328 A1 discloses an illumination unit with a flexible substrate and a plurality of electrical tracks including an anode track and a cathode track formed on the flexible substrate.

Document US 6,520,669 discloses a lighting assembly for use on vehicles which include a flexible substrate on which are mounted a plurality of light emitting diodes connected to flexible conductive traces provided on the flexible substrate. The flexible substrate is adapted to be mounted on the exterior surface of a vehicle, for example, as a tail lamp assembly, or as a headlamp. However, this document does not solve the aforementioned problems.

The purpose of the invention is to reduce the weight and cost of such a FPCB, but avoiding the aforementioned issues.

### DESCRIPTION OF THE INVENTION

The invention provides a solution for this problem by means of an electronic device according to claim 1 and a lighting module according to claim 9. Preferred embodiments of the invention are defined in dependent claims.

In an inventive aspect, the invention provides an electronic device for an automotive lighting module, the electronic device comprising
a connector;
a plurality of first light sources and a plurality of second light sources;
a first portion of a conductive anode connecting the connector with the first light sources; and
a second portion of a conductive anode connecting the connector with the second light sources;
wherein the first portion of the conductive anode and the second portion of the conductive anode are directly connected to the connector.

This electronic device has a more reduced size than current electronic devices, since the fact that the conductive anode is divided into two portions which are both directly connected to the connector makes it unnecessary that the size of the electronic device is defined by the total number of light sources to be fed, but only by some of them.

In some particular embodiments, the electronic device further comprises
a printed circuit board where the two portions of the conductive anode are arranged; and
a plurality of conductive tracks electrically connecting the first light sources and the second light sources with the connector.

This embodiment is more robust, since the printed circuit board provides a physical structure where the elements may be laid on.

In some particular embodiments, the printed circuit board is a flexible circuit board.

This flexible circuit board provides a more versatile base for the elements of this electronic device. The electronic device comprising a flexible circuit board may be adapted to the shape of a lighting device where said electronic device is installed.

In these FPCBs, the word "flexible" has a perfectly clear meaning, because any person skilled in the art may distinguish a flexible PCB from a standard PCB.

In some particular embodiments, the printed circuit board contains one single layer.

These embodiments allow the use of an aluminium stiffener, due to the lack of a second layer. However, in some embodiments, more than one layer may be used, thus increasing the capacity of this PCB.

In some particular embodiments, the printed circuit board comprises a total length and a central zone comprised between the 40% and the 60% of the total length of the printed circuit board, and the connector is comprised in the central zone.

A substantially symmetric arrangement is more optimal, in the sense that, in this case, both sides of the connector would comprise substantially the same number of conductive tracks, thus making that the region which contains the maximum number of conductive tracks, which in these embodiments is any of the two halves of the printed circuit board, has the smallest size possible. This fact has manufacturing and processing advantages, since connectors may be smaller.

In some particular embodiments, each conductive track connects only one light source to the connector.

In these embodiments, individualized control of each light source is easier and the rest of the light sources are isolated from a single failure.

In some particular embodiments, the connector comprises at least a first side and a second side, in such a way that the first portion of the conductive anode is connected to the first side of the connector, and the second portion of the conductive anode is connected to the second side of the connector.

These embodiments aim a more compact size, since the portions of the conductive anode are connected to different sides of the connector. In other embodiments, they are connected to the same side of the connector, by means of a common connector, such as a conductive wire.

In some particular embodiments, the second side of the connector is opposite to the first side of the connector.

This particular arrangement allows a greater size saving, because it is the embodiment where the conductive tracks are farther from the others.

In some embodiments, at least some of the first and/or second light sources are controlled light sources, each one of these controlled light sources being individually controlled by control means.

These embodiments allow the light sources to be activated independently from each other. This arrangement may be useful, for instance, to turn on or off sequentially each light source from one side of the flexible circuit board to the other side, so as to perform a running turn indicator or any other animation suitable in this technical field.

In some particular embodiments, the first and second light sources are semiconductor light sources, such as LEDs.

Semiconductor light sources, such as LEDs, have proven to be more efficient than traditional light sources.

In another inventive aspect, the invention provides a lighting device comprising an electronic device according to any of the previous inventive aspect.

Such a lighting device may be smaller and lighter than those of the state of art.

In some particular embodiments, the lighting device further comprises a first optical element, being arranged and configured to shape the light beam received from the first and second light sources in a predetermined light pattern.

Such a lighting device is suitable for being used in an automotive vehicle.

In some particular embodiments, the lighting device is a turning indicator.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows an electronic device according to the state of the art.
Figure 2 shows an electronic device according to the invention.
Figure 3 shows two lighting devices according to the invention, installed in an automotive vehicle.

### DETAILED DESCRIPTION OF THE INVENTION

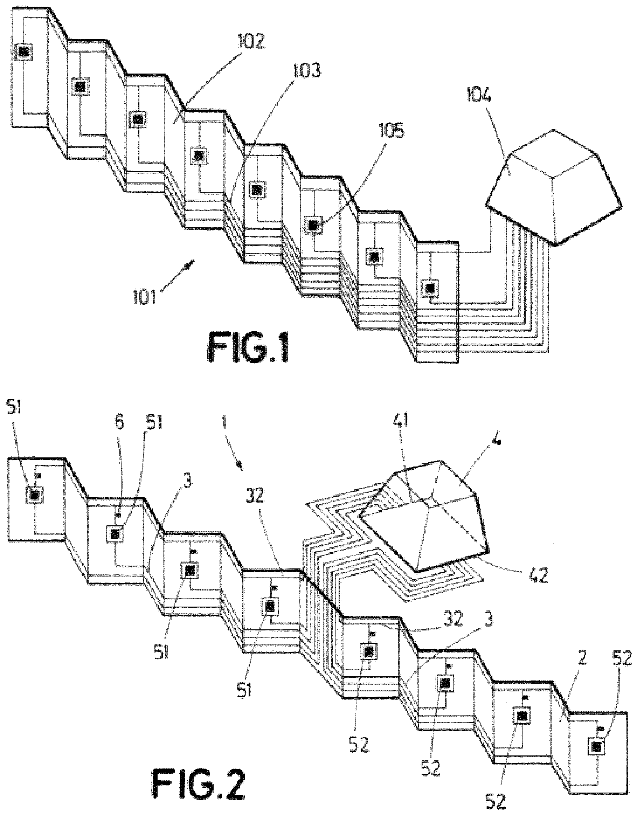

Figure 1 shows an electronic device 101 according to the state of the art, suitable for being installed in a lighting module. This electronic device 101 comprises
a flexible circuit board 102 comprising conductive tracks 103;
a connector 104 for connecting the conductive tracks 103 of the flexible circuit board 102 to an external electrical source; and
a plurality of light sources 105 in electrical connection with the connector 104 by means of the conductive tracks 103.

The connector 104 feeds the light sources 105 by means of the conductive tracks 103. However, the number of conductive tracks 103 is limited by the width of the flexible circuit board 102, which must include all the conductive tracks 103 which feed the light sources 105.

Figure 2 shows an electronic device 1 according to the invention, suitable for being installed in a lighting module. This electronic device 1 comprises
a flexible circuit board 2 comprising conductive tracks 3 and two portions 31, 32 of a conductive anode;
a connector 4 for connecting the conductive tracks 3 and the portions 31, 32 of the conductive anode to an external electrical source; and
a plurality of first and second light sources 51, 52 in electrical connection with the connector 4 by means of the conductive tracks 3 and the two portions 31, 32 of the conductive anode.

The first light sources 51 are connected to the connector 4 by means of the first portion of the conductive anode 31. In turn, the second light sources 52 are connected to the connector 4 by means of the second portion of the conductive anode 32.

Further, the first portion of the conductive anode 31 and the second portion of the conductive anode 32 are directly connected to the connector 4.

The connector 4 comprises a first side 41 and a second side 42 opposite to the first side 41, in such a way that the first portion of the conductive anode 31, together with some of the conductive tracks, is connected to the first side 41 of the connector 4. The second portion of the conductive anode 32, together with other conductive tracks, is connected to the second side 42 of the connector 4.

The connector 4 receives all the conductive tracks 3 and portions of the conductive anode 31, 32 which are arranged on the flexible circuit board 2, since electrical power is transmitted from the connector 4 to all the light sources 51, 52 which are present in the electronic device 1 by means of the conductive tracks 3 and of the portions of the conductive anode 31, 32.

The fact that the first portion of the conductive anode 31 is connected to the first side 41 of the connector and the second portion of the conductive anode 32 is connected to a second side 42 of the connector, and that the second side 42 is opposite to the first side 41 makes that the flexible circuit board 2 only needs to be wide enough to house half of the conductive tracks 3 than the embodiment known in the state of the art.

In the embodiment shown in this figure, the flexible circuit board 2 contains one single layer, since it is not necessary that conductive tracks 3 are arranged in different layers or sides of the flexible circuit board 2.

Although the flexible circuit board 2 is bended, it has a total length and a central zone comprised between the 40% and the 60% of the total length. The connector 4 is comprised in the central zone, so that approximately half of the conductive tracks 3 are connected to the first side 41 of the connector and approximately the other half of the conductive tracks 3 are connected to the second side 42 of the connector. Placing the connector 4 in this central zone minimizes the maximum number of conductive tracks 3 present in a cross section of the flexible circuit board, then minimizing the width thereof.

This arrangement is particularly advantageous when light sources are controlled light sources, each one of these controlled light sources being individually controlled by control means 6. As every conductive track 3 includes control means 6, the described arrangement of conductive tracks is even more advantageous.

In the embodiment shown in this figure, the light sources 51, 52 are semiconductor light sources, such as LEDs or laser light sources. This kind of light sources has severe restrictions regarding heat dissipation. Including a single layer of electronic parts makes heat dissipation easier. However, this electronic device is also suitable for including different types of light sources.

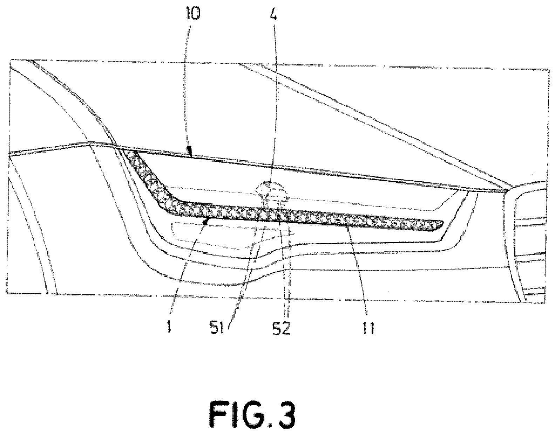

Figure 3 shows a lighting module 10 comprising an electronic device 1 according to any of the preceding claims.

Such a lighting module 10 is a turn indicator and also comprises a first optical element 11, being arranged and configured to shape light beams received from the light sources 51, 52 in a predetermined light pattern.

## Claims

1. Electronic device (1) for an automotive lighting module (10), the electronic device (1) comprising
a flexible printed circuit board (2) with conductive tracks (3) and a conductive anode arranged on the flexible circuit board (2);
a connector (4);
a plurality of first light sources (51) and a plurality of second light sources (52) mounted on said flexible printed circuit board (2) and being in electrical connection with the connector 4 by means of the conductive tracks 3 and the conductive anode;
**characterised in that** a first portion of said conductive anode (31) is connecting the connector with the first light sources (51);
a second portion of said conductive anode (32) is connecting the connector with the second light sources (52);
wherein the first portion of the conductive anode (31) and the second portion of the conductive anode (32) are directly connected to the connector (4).

2. Electronic device (1) according to claim 1, wherein the printed circuit board (2) contains one single layer.

3. Electronic device (1) according to any of the preceding claims, wherein the printed circuit board (2) has a total length and a central zone comprised between the 40% and the 60% of the total length of the printed circuit board (2), and the connector (4) is comprised in the central zone.

4. Electronic device (1) according to any of the preceding claims, wherein each conductive track (3) connects only one light source (5) to the connector (4).

5. Electronic device (1) according to any of the preceding claims, wherein the connector (4) comprises at least a first side (41) and a second side (42), in such a way that the first portion of the conductive anode (31) is connected to the first side (41) of the connector (4), and the second portion of the conductive anode (32) is connected to the second side (42) of the connector.

6. Electronic device (1) according to claim 5, wherein the second side (42) of the connector is opposite to the first side (41) of the connector.

7. Electronic device (1) according to any of the preceding claims, wherein at least some of the first and/or second light sources (51, 52) are controlled light sources, each one of these controlled light sources being individually controlled by control means (6).

8. Electronic device according to any of the preceding claims, wherein the first and second light sources (51, 52) are semiconductor light sources, such as LEDs.

9. Lighting module (10) comprising an electronic device (1) according to any of the preceding claims.

10. Lighting module (10) according to claim 9, the lighting module (10) further comprising a first optical element (11), being arranged and configured to shape light beams received from the first and second light sources (51, 52) in a predetermined light pattern.

11. Lighting module (10) according to any of claims 9 or 10, the lighting module (10) being a turning indicator.

## Patentansprüche

1. Elektronische Vorrichtung (1) für ein Kraftfahrzeugbeleuchtungsmodul (10), wobei die elektronische Vorrichtung (1) umfasst
eine flexible Leiterplatte (2) mit leitfähigen Bahnen (3) und einer leitfähigen Anode, auf der flexiblen Leiterplatte (2) angeordnet;
einen Verbinder (4);
mehrere erste Lichtquellen (51) und mehrere zweite Lichtquellen (52), auf der flexiblen Leiterplatte (2) montiert und in elektrischer Verbindung mit dem Verbinder 4 mit Hilfe der leitfähigen Bahnen 3 und der leitfähigen Anode stehend;
**dadurch gekennzeichnet, dass** ein erster Abschnitt der leitfähigen Anode (31) den Verbinder mit den ersten Lichtquellen (51) verbindet;
ein zweiter Abschnitt der leitfähigen Anode (32) den Verbinder mit den zweiten Lichtquellen (52) verbindet;
wobei der erste Abschnitt der leitfähigen Anode (31) und der zweite Abschnitt der leitfähigen Anode (32) direkt mit dem Verbinder (4) verbunden sind.

2. Elektronische Vorrichtung (1) nach Anspruch 1, wobei die Leiterplatte (2) eine einzelne Schicht enthält.

3. Elektronische Vorrichtung (1) nach einem der vorhergehenden Ansprüche, wobei die Leiterplatte (2) eine Gesamtlänge und eine mittlere Zone aufweist, beinhaltet zwischen den 40% und den 60% der Gesamtlänge der Leiterplatte (2), und der Verbinder (4) in der mittleren Zone beinhaltet ist.

4. Elektronische Vorrichtung (1) nach einem der vorhergehenden Ansprüche, wobei jede leitfähige Bahn (3) nur eine Lichtquelle (5) mit dem Verbinder (4) verbindet.

5. Elektronische Vorrichtung (1) nach einem der vorhergehenden Ansprüche, wobei der Verbinder (4) mindestens eine erste Seite (41) und eine zweite Seite (42) derart umfasst, dass der erste Abschnitt der leitfähigen Anode (31) mit der ersten Seite (41) des Verbinders (4) verbunden ist und der zweite Abschnitt der leitfähigen Anode (32) mit der zweiten Seite (42) des Verbinders verbunden ist.

6. Elektronische Vorrichtung (1) nach Anspruch 5, wobei die zweite Seite (42) des Verbinders der ersten Seite (41) des Verbinders gegenüberliegt.

7. Elektronische Vorrichtung (1) nach einem der vorhergehenden Ansprüche, wobei mindestens einige der ersten und/oder zweiten Lichtquellen (51, 52) gesteuerte Lichtquellen sind, wobei jede einzelne dieser gesteuerten Lichtquellen individuell durch Steuermittel (6) gesteuert wird.

8. Elektronische Vorrichtung nach einem der vorhergehenden Ansprüche, wobei die ersten und zweiten Lichtquellen (51, 52) Halbleiterlichtquellen wie etwa LEDs sind.

9. Beleuchtungsmodul (10) umfassend eine elektronische Vorrichtung (1) nach einem der vorhergehenden Ansprüche.

10. Beleuchtungsmodul (10) nach Anspruch 9, wobei das Beleuchtungsmodul (10) weiter ein erstes optisches Element (11) umfasst, das ausgelegt und konfiguriert ist zum Formen von von den ersten und zweiten Lichtquellen (51, 52) empfangenen Lichtstrahlen in einem vorbestimmten Lichtmuster.

11. Beleuchtungsmodul (10) nach einem der Ansprüche 9 oder 10, wobei das Beleuchtungsmodul (10) ein Abbiegeindikator ist.

## Revendications

1. Dispositif électronique (1) pour un module d'éclairage automobile (10), le dispositif électronique (1) comprenant :
une carte de circuit imprimé flexible (2) avec des pistes conductrices (3) et une anode conductrice disposée sur la carte de circuit flexible (2) ;
un connecteur (4) ;
une pluralité de premières sources de lumière (51) et une pluralité de secondes sources de lumière (52) montées sur ladite carte de circuit imprimé flexible (2) et étant en connexion électrique avec le connecteur 4 au moyen des pistes conductrices 3 et de l'anode conductrice ;
**caractérisé en ce qu'**une première partie de ladite anode conductrice (31) relie le connecteur aux premières sources lumineuses (51) ;
une seconde partie de ladite anode conductrice (32) relie le connecteur aux secondes sources de lumière (52) ;
où la première partie de l'anode conductrice (31) et la seconde partie de l'anode conductrice (32) sont connectées directement au connecteur (4).

2. Dispositif électronique (1) selon la revendication 1, dans lequel la carte de circuit imprimé (2) contient une seule couche.

3. Dispositif électronique (1) selon l'une quelconque des revendications précédentes, dans lequel la carte de circuit imprimé (2) présente une longueur totale et une zone centrale comprise entre 40 % et 60 % de la longueur totale de la carte de circuit imprimé (2), et le connecteur (4) est compris dans la zone centrale.

4. Dispositif électronique (1) selon l'une quelconque des revendications précédentes, dans lequel chaque piste conductrice (3) relie uniquement une seule source lumineuse (5) au connecteur (4).

5. Dispositif électronique (1 ) selon l'une quelconque des revendications précédentes, dans lequel le connecteur (4) comprend au moins un premier côté (41) et un second côté (42), de telle sorte que la première partie de l'anode conductrice (31) est connectée au premier côté (41) du connecteur (4), et la seconde partie de l'anode conductrice (32) est connectée au second côté (42) du connecteur.

6. Dispositif électronique (1) selon la revendication 5, dans lequel le second côté (42) du connecteur est opposé au premier côté (41) du connecteur.

7. Dispositif électronique (1) selon l'une quelconque des revendications précédentes, dans lequel au moins certaines des premières et/ou secondes sources lumineuses (51 , 52) sont des sources lumineuses commandées, chacune de ces sources lumineuses commandées étant commandée individuellement par les moyens de commande (6).

8. Dispositif électronique selon l'une quelconque des revendications précédentes, dans lequel les premières et secondes sources lumineuses (51, 52) sont des sources lumineuses à semi-conducteurs, telles que des LED.

9. Module d'éclairage (10) comprenant un dispositif électronique (1) selon l'une quelconque des revendications précédentes.

10. Module d'éclairage (10) selon la revendication 9, le module d'éclairage (10) comprenant en outre un premier élément optique (11), étant agencé et configuré pour mettre en forme les faisceaux lumineux reçus des première et seconde sources lumineuses (51, 52) selon un motif lumineux prédéterminé.

11. Module d'éclairage (10) selon l'une quelconque des revendications 9 ou 10, le module d'éclairage (10) étant un indicateur de type clignotant.
